Europäisches Patentamt

European Patent Office

Office européen des brevets

(11) Veröffentlichungsnummer: **0 356 548 B1**

## (12) EUROPÄISCHE PATENTSCHRIFT

(45) Veröffentlichungstag der Patentschrift: **10.03.93**

(51) Int. Cl.⁵: **H04L 7/02**, H03L 7/08

(21) Anmeldenummer: **88114139.4**

(22) Anmeldetag: **30.08.88**

(54) Verfahren und Schaltungsanordnung für eine digitale Regelung der Frequenz und/oder der Phase von Abtasttaktimpulsen.

(43) Veröffentlichungstag der Anmeldung:
**07.03.90 Patentblatt 90/10**

(45) Bekanntmachung des Hinweises auf die Patenterteilung:
**10.03.93 Patentblatt 93/10**

(84) Benannte Vertragsstaaten:
**AT BE CH DE FR GB IT LI NL SE**

(56) Entgegenhaltungen:
**EP-A- 0 092 400**
**DE-A- 3 532 857**

(73) Patentinhaber: **SIEMENS AKTIENGESELL-
SCHAFT
Wittelsbacherplatz 2
W-8000 München 2(DE)**

(72) Erfinder: **Schenk, Heinrich, Dr. Ing.
Becker-Gundahl-Strasse 1
W-8000 München 71(DE)**

**Beschreibung**

Die Erfindung betrifft ein Verfahren und eine Schaltungsanordnung gemäß Oberbegriff des Patentanspruchs 1.

Es ist bereits ein Verfahren für eine digitale Regelung der Phase von Abtasttaktimpulsen in einer Teilnehmeranschlußschaltung eines diensteintegrierenden Digitalnetzes bekannt ("telcom report", 8 (1985), Sonderheft "Diensteintegrierendes Digitalnetz ISDN", "Die Teilnehmeranschlußtechnik im ISDN", Gero Schollmeier. Bei dieser bekannten Teilnehmeranschlußschaltung werden einer Empfangseinrichtung zu durch das Auftreten der Abtasttaktimpulse festgelegten Zeitabständen Abtastproben in analoger Form empfangener Digitalsignale nach einer Analog-Digital-Wandlung für eine Umsetzung der empfangenen Digitalsignale zugeführt. Aus den empfangenen Digitalsignalen werden mit Hilfe einer Taktregelung und einer Takterzeugung, auf deren schaltungstechnische Realisierung nicht eingegangen wird, die genannten Abtasttaktimpulse abgeleitet.

Darüber hinaus ist es bereits bekannt ("Unterrichtsblätter der Deutschen Bundespost", Jahrgang 34/1981, Nr.2, Seiten 75-83), in digitalen Übertragungssystemen für eine Taktrückgewinnung Phasenregelkreise mit einem Schleifenfilter in Form eines Tiefpasses geringer Bandbreite vorzusehen, um Phasenschwankungen (Phasenjitter) des Leitungssignals, die durch die Übertragungsstrecke hervorgerufen sind, zu unterdrücken.

Auf die Realisierung eines derartigen Schleifenfilters wird jedoch nicht eingegangen.

Es ist nun Aufgabe der vorliegenden Erfindung, einen Weg zu zeigen, wie bei einem Verfahren und einer Schaltungsanordnung gemäß Oberbegriff des Patentanspruches 1 in einfacher Weise eine Filterung der für eine Frequenz- und/oder Phasenregelung von Abtasttaktimpulsen vorgesehenen Regelsignale vorgenommen werden kann.

Gelöst wird die vorstehend aufgezeigte Aufgabe bei einem Verfahren gemäß Oberbegriff des Patentanspruches 1 durch die im kennzeichnenden Teil dieses Patentanspruches angegebenen Merkmale. Der Vorteil der Erfindung besteht in einem schnellen Einschwingen des Taktregelsystems und in einem geringen Phasenjitter im eingeschwungenen Zustand .

Der Phasenjitter kann insbesondere dann geringgehalten werden, wenn die Quantisierung hinsichtlich des Quantisierungsfehlers mittelwertfrei durchgeführt wird.

Darüber hinaus ist es zweckmäßig, daß in einer Digitalsignal-Empfangseinrichtung mit einer durch einen Haupt-Entzerrerkoeffizienten und eine Mehrzahl von diesem vorangehenden bzw. nachfolgenden Entzerrerkoeffizienten einstellbaren Entzerreranordnung den gefilterten Regelsignalen vor der Quantisierung der dem Haupt-Entzerrerkoeffizienten unmittelbar vorangehende bzw. nachfolgende ggf. durch einen festgelegten Faktor gewichtete Entzerrerkoeffizient hinzugefügt wird. Die Größe dieses Entzerrerkoeffizienten ist abhängig von der Phasenlage der Abtasttaktimpulse und enthält somit eine Taktinformation. Durch das Hinzufügen dieses Entzerrerkoeffizienten zu den gefilterten Regelsignalen erfolgt die Taktregelung mit einer höheren Geschwindigkeit, ohne den Phasenjitter wesentlich zu erhöhen.

Eine Schaltungsanordnung zur Durchführung des Verfahrens gemäß der vorliegenden Erfindung sowie deren vorteilhafte Ausgestaltungen ergeben sich aus den Patentansprüchen 4 bis 9.

Der Vorteil dieser Schaltungsanordnung besteht in dem geringen schaltungstechnischen Aufwand für die Realisierung der Filteranordnung sowie der mit dieser verbundenen Einrichtungen.

Im folgenden wird nun die vorliegende Erfindung anhand von Zeichnungen näher erläutert.

Figur 1 zeigt eine Digitalsignal-Empfangseinrichtung, bei der die vorliegende Erfindung angewandt ist,

Figur 2 zeigt den Aufbau einer Filteranordnung, eines dieser nachgeschalteten Quantisierers sowie einer mit der Filteranordnung verbundenen Steuereinrichtung, die in Figur 1 lediglich schematisch dargestellt sind,

Figur 3 zeigt eine zwischen Filteranordnung und Quantisierer zwischengeschaltete Zusatzeinrichtung und

Figur 4 zeigt ein weiteres Ausführungsbeispiel für die in Figur 1 dargestellte Filteranordnung.

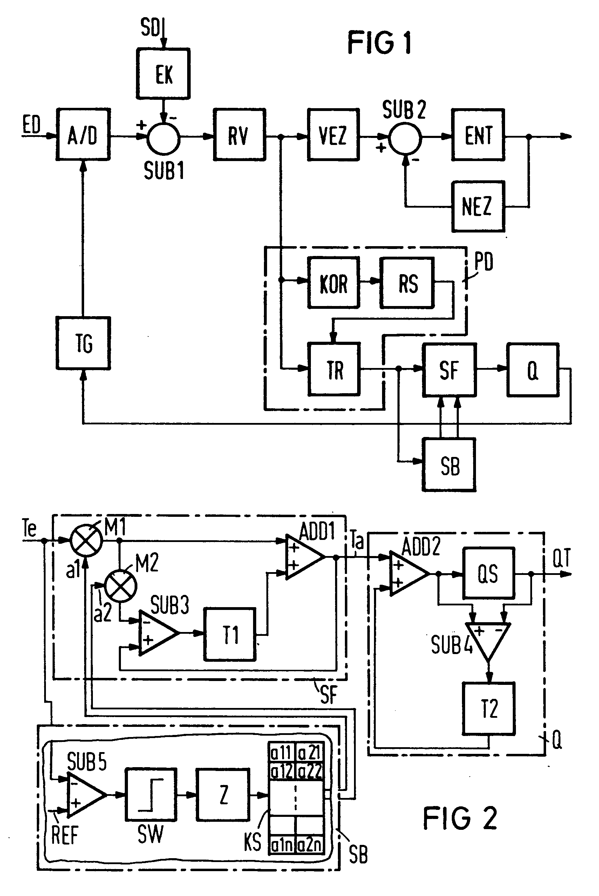

Die in Figur 1 dargestellte Digitalsignal-Empfangseinrichtung stellt in schematischer Form den Empfänger einer Teilnehmeranschlußschaltung für das diensteintegrierende Digitalnetz ISDN dar. Die Teilnehmeranschlußschaltung möge dabei für eine Duplexübertragung von Digitalsignalen über eine Zweidraht-Leitung im Gleichlage-Verfahren ausgelegt sein. Von einer solchen Teilnehmeranschlußschaltungwerden beispielsweise als Nachrichtensignale über die Zweidraht-Leitung zu übertragende Binärsignale zunächst in mehrstufige Signale, beispielsweise dreistufige Signale, umgesetzt und nach einer Impulsformung als analoge Signale in einem Datenblock über eine Gabelanordnung abgegeben. In einem solchen Datenblock, der beispielsweise 120 Bit umfassen möge, sind zusätzlich zu den Nachrichtensignalen Synchronisierinformationen enthalten. Als Synchronisierinformationen ist bei dem vorliegenden Ausführungsbeispiel ein Barker-Codewort mit einer Länge von 11 Bit gewählt.

2

Von der betreffenden Teilnehmeranschlußschaltung über die Zweidraht-Leitung aufzunehmende analoge Signale durchlaufen zunächst die bereits erwähnte Gabelanordnung und gelangen anschließend zu der in Figur 1 dargestellten Digitalsignal-Empfangseinrichtung. Den Eingang dieser Empfangseinrichtung bildet ein Analog-Digital-Wandler A/D, der den ihm zugeführten analogen Signalen Abtastproben beispielsweise in einem einer Bitlänge der in einem Datenblock übertragenen Signale entsprechenden Abstand entnimmt und diese jeweils in ein 16-Bit-Digitalsignal umsetzt. Die dafür erforderlichen Abtasttaktimpulse werden von einem regelbaren Taktgenerator TG bereitgestellt.

Die 16-Bit-Digitalsignale werden anschließend nacheinander einem Subtrahierer SUB1 zugeführt, der gleichzeitig mit Kompensationssignalen von einem Echokompensator EK her beaufschlagt ist. Durch diese Kompensationssignale werden in den 16-Bit-Digitalsignalen enthaltene Echosignalanteile kompensiert, die bei der zuvor beschriebenen Abgabe von Datenblöcken über die Zweidraht-Leitung durch Reflexionen auf dieser Leitung beziehungsweise durch eine nicht vollständige Entkopplung der Übertragungswege der Gabelanordnung den empfangenen analogen Signalen überlagert sind.

Die kompensierten Digitalsignale werden anschließend für eine weitere Verarbeitung über einen Regelverstärker RV und eine Entzerrer-Anordnung weitergeleitet, die die durch die elektrischen Eigenschaften der Zweidraht-Leitung bedingten Verzerrungen weitgehend beseitigt. Die Entzerrer-Anordnung weist dabei beispielsweise einen Vorschwinger-Entzerrer VEZ auf, dessen Ausgangssignale einem Subtrahierer SUB2 zugeführt sind. Ein zweiter Eingang dieses Subtrahierers ist mit dem Ausgang eines Nahschwinger-Entzerrers NEZ verbunden. Eingangsseitig ist dieser Entzerrer an dem Ausgang eines Entscheiders ENT angeschlossen, der dem Subtrahierer SUB2 nachgeschaltet ist.

Auf die zuvor genannten Schaltungsteile der in Figur 1 dargestellten Digitalsignal-Empfangseinrichtung wird im folgenden nicht näher eingegangen, da deren Wirkungsweise bereits hinlänglich bekannt ist.

Mit dem Ausgang des zuvor genannten Regelverstärkers RV ist ein Phasendiskriminator PD verbunden, der aus den ihm zugeführten Signalen Phasenregelsignale ableitet, die proportional zu der gerade bestehenden Regelabweichung sind. Bei dem vorliegenden Ausführungsbeispiel weist der Phasendiskriminator einen Korrelator KOR auf, der eingangsseitig mit dem Ausgang des Regelverstärkers RV und ausgangsseitig mit einer Rahmensynchronisier-Einrichtung RS verbunden ist.

Mit Hilfe dieser beiden Einrichtungen werden aus den am Ausgang des Regelverstärkers RV auftretenden Signalen Rahmentaktimpulse gewonnen, die zusammen mit den am Ausgang des Regelverstärkers auftretenden Signalen einer Taktregeleinrichtung TR zugeführt sind. Diese Taktregeleinrichtung leitet daraus während des Empfangs der oben erwähnten Synchronisierinformationen der jeweils gerade vorliegenden Regelabweichung proportionale Regelsignale ab.

Bezüglich des Phasendiskriminators PD sei noch darauf hingewiesen, daß zwar vorstehend eine mögliche Ausführungsform beschrieben ist. Die Ausführungsform ist jedoch nicht wesentlich für die vorliegende Erfindung. Vielmehr wird lediglich vorausgesetzt, daß der Phasendiskriminator aus den ihm zugeführten Signalen Regelsignale ableitet, die proportional zu den vorliegenden Regelabweichungen sind. So wäre es beispielsweise auch möglich, daß der Phasendiskriminator bei einer Nachrichtensignalübertra-gung über eine Zweidraht-Leitung ohne Synchronisierinformationen die Regelsignale direkt aus den empfangenen Nachrichtensignalen ableitet.

Die von dem Phasendiskriminator PD abgegebenen Regelsignale weisen im allgemeinen Rauschanteile auf. Für die Unterdrückung dieser Rauschanteile und damit für das Erreichen eines geringen Phasenjitters durchlaufen die Regelsignale ein schmalbandiges, von einer Regelsignal-Bewertungseinrichtung SB her gesteuertes Schleifenfilter SF. Die gefilterten Regelsignale werden anschließend einem Quantisierer Q zugeführt, der an seinem Ausgang jeweils 4 Bit umfassende quantisierte Regelsignale bereitstellt, mit denen der bereits genannte regelbare Taktgenerator TG für eine Regelung der Frequenz und/oder der Phase der Abtasttaktimpulse beaufschlagt ist. Der Taktgenerator möge dafür beispielsweise einen durch die zugeführten Regelsignale einstellbaren Taktteiler aufweisen.

Figur 2 zeigt den möglichen Aufbau des Schleifenfilters SF, des Quantisierers Q und der mit dem Schleifenfilter verbundenen Regelsignal-Bewertungseinrichtung SB. Das Schleifenfilter weist eingangsseitig einen Multiplizierer M1 auf, dem die von dem Phasendiskriminator PD her abgegebenen Regelsignale TE und ein Filterkoeffizient a1 zugeführt sind. Das daraus resultierende Produktsignal gelangt einerseits an einen ersten Eingang eines Addierers ADD1 und andererseits an einen Eingang eines Multiplizierers M2, welcher an einem zweiten Eingang einen Filterkoeffizienten a2 zugeführt erhält. Das Ausgangssignal dieses Multiplizierers wird an einen Eingang (-) eines Subtrahierers SUB3 weitergeleitet. Ein weiterer Eingang (+) dieses Subtrahierers ist an den Ausgang des genannten Addierers ADD1 angeschlossen.

Der Ausgang des Subtrahierers SUB3 wird über ein beispielsweise als Speicher ausgeführtes Verzögerungsglied T1, dessen Zeitkonstante dem zeitlichen Abstand zweier aufeinanderfolgender Regelsignale entspricht, einem zweiten Eingang des Addierers ADD1 zugeführt.

3

Das gerade beschriebene Schleifenfilter liefert an seinem Ausgang Regelsignale in der Form

Ta(i) = a1(Te(i)-a2Te(i-1)) + Ta(i-1) mit i = 1,...,n.

Dabei bedeuten a1, a2 einen Filterkoeffizienten-Satz, Ta(i) und Ta(i-1) am Ausgang des Schleifenfilters auftretende Regelsignale zu den Zeitpunkten i und (i-1) und Te(i) und Te(i-1) zu den Zeitpunkten i und (i-1) von den Phasendiskriminator PD bereitgestellte Regelsignale.

Die von dem Schleifenfilter SF abgegebenen gefilterten Regelsignale werden einem Addierer ADD2 des Quantisierers Q zugeführt. Der Ausgang dieses Addierers ist mit einer Quantisierungsstufe QS verbunden, welche jeweils 4 Bit umfassende quantisierte Regelsignale QT abgibt. Diese werden einerseits, wie bereits vorstehend erläutert, dem Taktgenerator TG und anderrerseits einem Eingang eines Subtrahierers SUB4 zugeführt. Ein weiterer Eingang dieses Subtrahierers ist mit dem Eingang der Quantisierungsstufe QS verbunden. Am Ausgang des Subtrahierers tritt damit ein Fehlersignal auf, welches dem durch die Quantisierung bedingten Quantisierungsfehler entspricht. Dieses Fehlersignal wird an ein beispielsweise in Form eines Speichers gebildetes Verzögerungsglied T2 weitergeleitet, dessen Zeitkonstante dem Abstand zweier aufeinanderfolgender quantisierter Regelsignale entspricht. Der Ausgang dieses Verzögerungsgliedes ist mit einem zweiten Eingang des bereits genannten Addierers ADD2 verbunden. Damit wird ein zu einem Zeitpunkt (i-1) ermitteltes Fehlersignal dem zu dem Zeitpunkt i auftretenden gefilterten Regelsignal hinzugefügt. Durch diese Rückführung des Fehlersignals ist der durch die Quantisierung bedingte Quantisierungsfehler mittelwertfrei.

In Figur 2 ist außerdem eine Regelsignal-Bewertungseinrichtung SB dargestellt. Diese Bewertungseinrichtung erhält die von dem Phasendiskriminator PD abgegebenen Regelsignale zugeführt. Der Betrag dieser Regelsignale wird mit Hilfe eines Subtrahierers SUB5 jeweils mit einem festgelegten Referenzwert REF verglichen. Liegt dabei der Betrag eines Regelsignals oberhalb des Referenzwertes, so wird am Ausgang einer dem Subtrahier nachgeschalteten Schwellwertstufe SW ein Impuls mit einem ersten logischen Pegel, beispielsweise +1, abgegeben. Liegt dagegen der Betrag eines Regelsignals unterhalb des Referenzwertes, so tritt am Ausgang der Schwellwertstufe ein Impuls mit einem zweiten logischen Pegel auf, beispielsweise -1. Die Impulse der ersten und zweiten Art werden einer Vor-Rückwärts-Zähleranordnung Z als Zählimpulse zugeführt.

Ein Impuls der ersten Art bewirkt dabei ein Dekrementieren, ein Impuls der zweiten Art dagegen ein Inkrementieren des Zählerstandes. Der minimale Zählerstand und der maximale Zählerstand sind dabei fest vorgegeben, beispielsweise mit 0 und 63.

Den Zählerständen entsprechende Ausgangssignale der Zähleranordnung Z dienen einem Koeffizienten-Speicher KS als Adressensignale. In diesem Koeffizienten-Speicher sind in diesen Adressensignalen zugeordneten Speicherzellen Filterkoeffizienten-Sätze a11, a21;...; a1n, a2n gespeichert. Von diesen Filterkoeffizienten-Sätzen wird zu einem vorgegebenen Zeitpunkt nach Maßgabe des gerade anliegenden Adressensignals ein Satz ausgewählt und dem Schleifenfilter SF als Filterkoeffizienten-Satz a1, a2 zugeführt. Beispielsweise können die Filterkoeffizienten a21, ...a2n mit jeweils $2^{-4}$ festgelegt sein, während die Filterkoeffizienten a11, ..., a1n in Abhängigkeit vom Zählerstand der Zähleranordnung Z nach folgender Tabelle ausgewählt werden.

| Zählerstand | a1 |
|---|---|
| 0 ... 7 | a11 |
| 8 ... 31 | a12 $= $ a11 x $2^{-3}$ |
| 32 ... 62 | a13 $= $ a11 x $2^{-5}$ |
| 63 | a14 $= $ a11 x $2^{-7}$ |

Durch die Bereitstellung einer Mehrzahl von unterschiedlichen Filterkoeffizienten-Sätzen in Abhängigkeit von der Regelsignalabweichung ist ein schnelles Einschwingen des in Figur 1 dargestellten Taktregelkreises sichergestellt. Das zuvor beschriebene Schleifenfilter eigent sich somit für Digitalsignal-Empfangseinrichtungen, in welchen eine Frequenzregelung und/oder Phasenregelung für Abtasttaktimpulse durchzuführen ist.

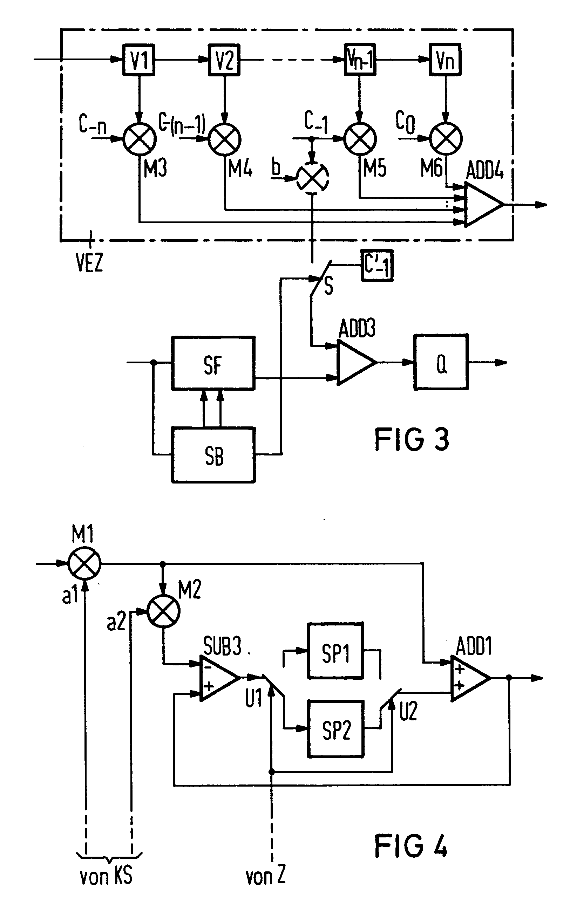

In Figur 3 ist dem zuvor erwähnten Quantisierer Q eine Zusatzeinrichtung in Form eines Addierers ADD3 vorgeschaltet. Das Schleifenfilter SF ist an einen Eingang dieses Addierers angeschlossen. Ein zweiter Eingang steht über einen steuerbaren elektronischen Schalter S mit einem der in Figur 1 dargestellten Entzerrer in Verbindung. Bei dem Entzerrer möge es sich beispielsweise um den Vorschwinger-Entzerrer VEZ handeln. Dieser Vorschwinger-Entzerrer ist als bekanntes Transversal-Filter mit einer Mehrzahl von in Reihe geschalteten Verzögerungsgliedern V1 bis Vn dargestellt. Die Ausgänge diese Verzögerungsglieder sind jeweils mit einem Multiplizierer (M3 bis M6) verbunden. Mit Hilfe dieser Multiplizierer werden die an den Ausgängen der Verzögerungsglieder auftretenden Signale jeweils mit einem Entzerrerkoeffizienten multipliziert. Der dem Multiplizierer M6 zugeführte Entzerrerkoeffizient $C_0$ stellt dabei den Haupt-Entzerrerkoeffizienten dar. Die einzelnen Produktsignale werden dann anschließend mit Hilfe eines Addierers ADD4 aufsummiert.

Über den genannten Schalter S ist der dem Haupt-Entzerrerkoeffizient $C_0$ unmittelbar vorangehende Entzerrerkoeffizient $C_{-1}$ dem Addierer ADD3 zugeführt. Die Größe dieses Entzerrerkoeffizienten ist abhängig von der Phasenlage der von dem Taktgenerator TG abgegebenen Abtasttaktimpulse. Der Entzerrerkoeffizient enthält somit eine Taktinformation, die für eine schnellere Taktregelung ausgenutzt wird.

Der Schalter S ist von der der Regelsignal-Bewertungseinrichtung SB zugehörigen Zähleranordnung Z her derart steuerbar, daß dieser lediglich dann den Entzerrerkoeffizienten $C_{-1}$ weiterleitet, wenn der Zählerstand dieser Zähleranordnung einen vorgegebenen Zählerstand überschreitet. Vor Erreichen dieses vorgegebenen Zählerstandes wird dagegen ein fester Wert $C'_{-1}$ als Entzerrerkoeffizient dem Addierer ADD3 bereitgestellt. Durch diese Steuerung des Schalters S wird somit in der Einschwingphase des Taktregelkreises, d. h. bei einer oberhalb eines vorgegebenen Referenzwertes liegenden Regelsignalabweichung, eine Verkopplung zwischen Taktregelkreis und Entzerrer vermieden.

Im Übrigen sei noch darauf hingewiesen, daß in die Taktregelung anstelle des Vorschwinger-Entzerrers VEZ auch der Nachschwinger-Entzerrer NEZ einbezogen seien kann. In diesem Falle wird dem Addierer ADD3 der dem Haupt-Entzerrerkoeffizienten $C_0$ unmittelbar nachfolgende Entzerrerkoeffizient $C_1$ zugeführt. Darüber hinaus kann dem Addierer ADD3 auch, wie in Figur 3 angedeutet ist, ein durch einen vorgegebenen Faktor b gewichteter Entzerrerkoeffizient ($bC_{-1}$ bzw. $bC_{+1}$) bereitgestellt sein. Durch die Größe und das Vorzeichen dieses Faktors erfolgt ggf. eine Anpassung an das Taktregelsystem. Alternativ kann der Schalter S auch entfallen, wenn der jeweilige Entzerrer erst bei Überschreiten eines vorgegebenen Zählerstandes der Zähleranordnung Z für eine Koeffizientenregelung aktiviert wird und bis zu diesem Zeitpunkt die bei einer vorangegangenen Digitalsignal-Übertragung ermittelten Entzerrerkoeffizienten gespeichert sind.

In Figur 4 ist ein zweites Ausführungsbeispiel für das in Figur 2 dargestellte Schleifenfilter SF gezeigt. Bei diesem Ausführungsbeispiel sind anstelle des Verzögerungsgliedes T1 zwei Speicher SP1 und SP2 vorgesehen. Diese Speicher sind über zwei Umschalter U1 und U2 wahlweise zwischen den Subtrahierer SUB3 und den Addierer ADD1 schaltbar. Der Speicher SP2 wird dabei angeschaltet, wenn der Zählerstand der Zähleranordnung Z (Figur 2) unterhalb eines vorgegebenen Wertes, beispielsweise 32, liegt. In diesem Zustand wird gleichzeitig ein erster Filterkoeffizienten-Satz a1, a2 dem Schleifenfilter SF zugeführt. Liegt dagegen der Zählerstand der Zähleranordnung Z unterhalb des genannten vorgegebenen Wertes, so wird der Speicher SP1 angeschaltet und ein zweiter Filterkoeffizienten-Satz a1, a2 dem Schleifenfilter bereitgestellt. Bei der Umschaltung zwischen dem Speicher SP1 und SP2 bleibt im übrigen der in dem jeweiligen Speicher gerade enthaltene Wert gespeichert. Mit diesem gespeicherten Wert kann beispielsweise bei einer späteren Digitalsignal-Übertragung zu der in Figur 1 dargestellten Digitalsignal-Einrichtung hin eine erneute Taktregelung begonnen werden.

Das in Figur 4 dargestellte Ausführungsbeispiel für das Schleifenfilter SF, bei dem lediglich zwei unterschiedliche Filterkoeffizienten-Sätze benutzt sind, ist dann vorteilhaft anwendbar, wenn zwischen zwei aufeinanderfolgende Digitalsignal-Übertragungen zu einer Digitalsignal-Empfangseinrichtung hin sich die Frequenzverhältnisse nicht wesentlich ändern.

Abschließend sei noch darauf hingewiesen, daß zwar vorstehend die vorliegende Erfindung am Beispiel einer Digitalsignal-Empfangseinrichtung für den Empfang von Digitalsignalen über eine Zweidraht-Leitung beschrieben worden ist. Die Erfindung ist jedoch allgemein immer dann einsetzbar, wenn in einer Digitalsignal-Empfangseinrichtung mit Hilfe eines Taktregelkreises anhand der empfangenen Signale eine Regelung der Frequenz und/oder der Phase von Abtasttaktimpulsen durchzuführen ist.

**Patentansprüche**

1. Verfahren für eine digitale Regelung der Frequenz und/oder der Phase von Abtasttaktimpulsen in einer Digitalsignal-Empfangseinrichtung, welcher zu durch das Auftreten der Abtasttaktimpulse festgelegten Zeitabständen Abtastproben in analoger Form empfangener Digitalsignale nach einer Analog-Digital-Wandlung für eine Umsetzung der empfangenen Digitalsignale zugeführt werden und in welcher aus den empfangenen Digitalsignalen abgeleitete Regelsignale bereitgestellt werden, die nach einer Filterung in vorgegebenen Zeitabständen einem Taktgenerator für die Abgabe der Abtasttaktimpulse zugeführt werden, **dadurch gekennzeichnet**, daß die Filterung der Regelsignale in der Form

$$Ta(i) = a1(Te(i) - a2\,Te(i-1)) + Ta(i-1) \text{ mit } i = 1,...,n$$

durchgeführt wird, wobei a1, a2 einen vorgegebenen Filterkoeffizienten-Satz, Ta(i) und Ta(i-1) gefilterte Regelsignale zu den Zeitpunkten i und (i-1) und Te(i) und Te(i-1) zu den Zeitpunkten i und (i-1) bereitgestellte Regelsignale darstellen,
daß wenigstens zwei voneinander abweichende Filterkoeffizienten-Sätze nach Maßgabe des Betrags der momentanen Regelsignalabweichung ausgewählt werden
und daß die gefilterten Regelsignale in quantisierter Form dem Taktgenerator zugeführt werden.

2. Verfahren nach Anspruch 1, **dadurch gekennzeichnet**,
daß die Quantisierung der gefilterten Regelsignale mittelwertfrei durchgeführt wird.

3. Verfahren nach Anspruch 1 oder 2, **dadurch gekennzeichnet**,
daß in einer Digitalsignal-Empfangseinrichtung mit einer durch einen Haupt-Entzerrerkoeffizienten und eine Mehrzahl von diesem vorangehenden bzw. nachfolgenden Entzerrerkoeffizienten einstellbaren Entzerreranordnung den gefilterten Regelsignalen vor der Quantisierung der dem Haupt-Entzerrerkoeffizienten unmittelbar vorangehende bzw. nachfolgende ggf. durch einen festgelegten Faktor gewichtete Entzerrerkoeffizient hinzugefügt wird.

4. Schaltungsanordnung zur Durchführung des Verfahrens nach Anspruch 1 mit einer Digitalsignal-Empfangseinrichtung, welche einen aus einem Phasendiskriminator (PD) und einem durch diesen regelbaren Taktgenerator (TG) bestehenden Taktregelkreis aufweist, wobei der Phasendiskriminator mit den Abtastproben empfangener Digitalsignale beaufschlagt ist und aus den Abtastproben Regelsignale ableitet, die dem Taktgenerator in vorgegebenen Zeitabständen über eine Filteranordnung (SF) zugeführt sind, **dadurch gekennzeichnet**,
daß die Filteranordnung (SF) Regelsignale in der Form

$$Ta(i) = a1(Te(i) - a2\,Te(i-1)) + Ta(i-1) \text{ mit } i = 1,...,n$$

bereitstellt, wobei a1, a2 einen Filterkoeffizienten-Satz, Ta(i) und Ta(i-1) gefilterte Regelsignale zu den Zeitpunkten i und (i-1) und Te(i) und Te(i-1) zu den Zeitpunkten i und (i-1) von dem Phasendiskriminator (PD) her bereitgestellte Regelsignale darstellen,
daß mit der Filteranordnung (SF) eine Regelsignal-Bewertungseinrichtung (SB) verbunden ist, welche mit den von dem Phasendiskriminator (PD) abgegebenen Regelsignalen beaufschlagt ist und nach Maßgabe der momentanen Abweichung des Betrags der Regelsignale von einem vorgegebenen Referenzwert einen von wenigstens zwei voneinander verschiedenen Filterkoeffizienten-Sätzen für das Schleifenfilter bereitstellt,
und daß die gefilterten Regelsignale über einen Quantisierer (Q) dem Taktgenerator (TG) zugeführt sind.

5. Schaltungsanordnung nach Anspruch 4, **dadurch gekennzeichnet**,
daß die Regelsignal-Bewertungseinrichtung (SB) eine Vergleicheranordnung (SUB5, SW) aufweist, welche durch ein Steuersignal an ihrem Ausgang anzeigt, ob ein gerade vorliegendes Regelsignal oberhalb oder unterhalb eines vorgegebenen Schwellwertes (REF) liegt, daß mit den Steuersignalen als Zählsignale eine Vor-Rückwärts-Zähleranordnung (Z) mit vorgegebenem Minimalwert und Maximalwert beaufschlagt ist
und daß die Vor-Rückwärts-Zähleranordnung den Zählerständen entsprechende Ausgangssignale als Adressensignale einer Filterkoeffizienten-Speicheranordnung (KS) zuführt, welche nach Maßgabe dieser Adressensignale Filterkoeffizienten-Sätze für das Schleifenfilter (SF) bereitstellt.

6. Schaltungssanordnung nach Anspruch 4 oder 5, **dadurch gekennzeichnet**,
daß der Quantisierer (Q) eingangsseitig einen Addierer (ADD2) mit 2 Eingängen aufweist, dessen einem Eingang die gefilterten Regelsignale zugeführt sind,
daß dem Addierer eine den Ausgang des Quantisierers bildende Quantisierungsstufe (QS) nachgeschaltet ist,
und daß mit der Quantisierungsstufe eine Einrichtung (SUB4, T2) verbunden ist, welche ein einem zu einem Zeitpunkt (i-1) auftretenden Quantisierungsfehler entsprechendes Fehlersignal zum Zeitpunkt i dem Eingang des Addierers (ADD2) zuführt.

**7.** Schaltungsanordnung nach einem der Ansprüche 4 bis 6, **dadurch gekennzeichnet**,
daß bei einer Digitalsignal-Empfangseinrichtung mit einer durch einen Haupt-Entzerrerkoeffizienten und eine Mehrzahl von diesem vorhergehenden bzw. nachfolgenden Entzerrer-Koeffizienten einstellbaren Entzerreranordnung (VEZ, NEZ) zwischen dem Schleifenfilter (SF) und dem Quantisierer (Q) ein Addierer (ADD3) mit zwei Eingängen geschaltet ist, dessen einem Eingang die gefilterten Regelsignale und dessen anderem Eingang der dem Haupt-Entzerrerkoeffizienten unmittelbar vorangehende bzw. nachfolgende ggf. durch einen festgelegten Faktor gewichtete Entzerrerkoeffizient zugeführt ist.

**8.** Schaltungsanordnung nach Anspruch 7, **dadurch gekennzeichnet**,
daß der Entzerrer-Koeffizient dem Addierer (ADD3) bei Erreichen eines vorgegebenen Zählerstandes der der Regelsignal-Bewertungseinrichtung (SB) zugehörigen Vor-Rückwärts-Zähleranordnung (Z) über eine Schalteranordnung (S) zugeführt ist.

**9.** Schaltungsanordnung nach einem der Ansprüche 5 bis 8, **dadurch gekennzeichnet**,
daß die Regelsignal-Bewertungseinrichtung (SB) lediglich zwei voneinander verschiedene Filterkoeffizienten-Sätze bereitstellt, daß dem Schleifenfilter (SF) zwei gesonderte Speicher (SP1, SP2) für die Speicherung von Teil-Regelsignalen a1a2Te(i-2) + Ta (i-1) zugehörig sind,
daß in die Bildung eines gefilterten Regelsignals bei einem oberhalb eines festgelegten Wertes liegenden Zählerstand der Vor-Rückwärts-Zähleranordnung Z ein erster Speicher (z. B. SP2) und ein erster Filterkoeffizienten-Satz, bei einem unterhalb des festgelegten Wertes liegenden Zählerstand dagegen der verbleibende Speicher und der verbleibende Filterkoeffizienten-Satz einbezogen sind und daß bei einem Wechsel der Speicher das in dem jeweiligen Speicher gerade enthaltene Teil-Regelsignal gespeichert bleibt.

**Claims**

**1.** Method for a digital control of the frequency and/or the phase of sampling clock pulses in a digital signal receiving device, to which samples of digital signals received in analog form are supplied, after an analog-digital conversion, at time intervals defined by the occurrence of the sampling clock pulses for a conversion of the received digital signals, and in which control signals derived from the received digital signals are provided which, after a filtering at given time intervals, are supplied to a clock generator for the output of the sampling clock pulses, characterised in that the filtering of the control signals is performed in the form

$$Ta(i) = a1(Te(i)-a2\ Te(i-1)) + Ta(i-1)\ \text{where } i = 1,...n,$$

where a1, a2 represent a given set of filter coefficients, Ta(i) and Ta(i-1) represent filtered control signals at the instants i and (i-1), and Te(i) and Te(i-1) represent control signals provided at the instants i and (i-1), in that at least two mutually different sets of filter coefficients are selected according to the magnitude of the instantaneous control signal deviation, and in that the filtered control signals are supplied to the clock generator in quantised form.

**2.** Method according to Claim 1, characterised in that the quantisation of the filtered control signals is performed without averaging.

**3.** Method according to Claim 1 or 2, characterised in that in a digital signal receiving device having an equaliser arrangement that can be adjusted by a main equaliser coefficient and a plurality of equaliser coefficients preceding or following the latter, before the quantisation the equaliser coefficient which immediately precedes or follows the main equaliser coefficient, and which is weighted by a fixed factor if appropriate, is added to the filtered control signals.

**4.** Circuit arrangement for carrying out the method according to Claim 1, having a digital signal receiving device having a clock control circuit comprising a phase discriminator (PD) and a clock generator (TG) that can be controlled by the latter, in which the phase discriminator receives the samples of received digital signals and from the samples derives control signals which are supplied to the clock generator via a filter arrangement (SF) at given time intervals, characterised in that the filter arrangement (SF) provides control signals in the form

Ta(i) = a1(Te(i) - a2 Te(i-1)) + Ta(i-1) where i = 1,...n,

where a1, a2 represent a set of filter coefficients, Ta(i) and Ta(i-1) represent filtered control signals at the instants i and (i-1), and Te(i) and Te(i-1) represent control signals provided by the phase discriminator (PD) at the instants i and (i-1), in that connected to the filter arrangement (SF) is a control signal analysing device (SB) which receives the control signals output by the phase discriminator (PD) and provides one of at least two mutually different sets of filter coefficients for the loop filter according to the instantaneous deviation of the magnitude of the control signals from a given reference value, and in that the filtered control signals are supplied to the clock generator (TG) via a quantiser (Q).

5. Circuit arrangement according to Claim 4, characterised in that the control signal analysing device (SB) has a comparator arrangement (SUB5, SW) which indicates by means of a control signal at its output whether a currently present control signal is above or below a given threshold value (REF), in that a bidirectional counter arrangement (Z) with a given minimum value and maximum value receives the control signals as counting signals, and in that the bidirectional counter arrangement supplies output signals corresponding to the counter readings as address signals to a filter coefficients memory arrangement (KS), which provides sets of filter coefficients for the loop filter (SF) in accordance with said address signals.

6. Circuit arrangement according to Claim 4 or 5, characterised in that the quantiser (Q) has on the input side an adder (ADD2) with 2 inputs, to one input of which the filtered control signals are supplied, in that a quantisation stage (QS) forming the output of the quantiser is connected downstream of the adder, and in that connected to the quantisation stage is a device (SUB4, T2) which supplies an error signal corresponding to a quantisation error occurring at an instant (i-1) to the input of the adder (ADD2) at the instant i.

7. Circuit arrangement according to one of Claims 4 to 6, characterised in that in a digital signal receiving device having an equaliser arrangement (VEZ, NEZ) that can be adjusted by a main equaliser coefficient and a plurality of equaliser coefficients preceding or following the latter, there is connected between the loop filter (SF) and the quantiser (Q) an adder (ADD3) with two inputs, the one input of which is supplied with the filtered control signals and the other input of which is supplied with the equaliser coefficient which immediately precedes or follows the main equaliser coefficient and which is weighted by a fixed factor if appropriate.

8. Circuit arrangement according to Claim 7, characterised in that the equaliser coefficient is supplied via a circuit arrangement (S) to the adder (ADD3) when a given counter reading of the bidirectional counter arrangement (Z) associated with the control signal analysing device (SB) is reached.

9. Circuit arrangement according to one of Claims 5 to 8, characterised in that the control signal analysing device (SB) provides only two mutually different sets of filter coefficients, in that two separate memories (SP1, SP2) for the storage of component control signals a1a2Te(i-2) + Ta (i-1) are associated with the loop filter (SF), in that a first memory (for example SP2) and a first set of filter coefficients are included in the formation of a filtered control signal given a counter reading of the bidirectional counter arrangement Z above a fixed value, and on the other hand the remaining memory and the remaining set of filter coefficients are included given a counter reading below the fixed value, and in that the component controls signal currently contained in the respective memory remains stored when the memories are changed.

**Revendications**

1. Procédé de régulation numérique de la fréquence et/ou de la phase d'impulsions de cadence d'échantillonnage dans un dispositif de réception de signaux numériques, auquel des échantillons sont envoyés sous la forme analogique de signaux numériques reçus, à des intervalles de temps fixés par l'apparition des impulsions de cadence d'échantillonnage, après conversion analogique/numérique pour une conversion des signaux numériques reçus et dans lequel sont préparés des signaux de régulation qui sont tirés des signaux numériques reçus et qui sont envoyés, après un filtrage pendant des intervalles de temps prédéterminés, à un générateur de cadence pour la délivrance des impulsions de cadence d'échantillonnage, caractérisé par le fait

que le filtrage des signaux de régulation est exécuté sous la forme

Ta(i) = a1(Te(i)-a2 Te(i-1)) + Ta(i-1) avec i = 1,...,n

a1, a2 étant un ensemble prédéterminé de coefficients de filtre, Ta(i) et Ta(i-1) des signaux filtrés de régulation apparaissant aux instants i et (i-1), et Te(i) et Te(i-1) représentant des signaux de régulation préparés aux instants i et (i-1),
qu'on choisit au moins deux ensembles, qui diffèrent l'un de l'autre, de coefficients de filtres en fonction de la valeur de l'écart instantané du signal de régulation, et
que les signaux filtrés de régulation sont envoyés sous forme quantifiée au générateur de cadence.

2. Procédé suivant la revendication 1, caractérisé par le fait que la quantification des signaux de régulation filtrés est exécutée sans valeur moyenne.

3. Procédé suivant la revendication 1 ou 2, caractérisé par le fait que dans un dispositif de réception de signaux numériques comportant un dispositif de correction des distorsions, qui est réglable au moyen d'un coefficient principal de correction des distorsions et d'une multiplicité de coefficients de correction des distorsions qui précèdent ou suivent ce coefficient principal, un coefficient de correction des distorsions éventuellement pondéré par un facteur fixe, et qui précède ou suit directement le coefficient principal de correction des distorsions, est ajouté aux signaux filtrés de régulation avant la quantification.

4. Montage pour la mise en oeuvre du procédé suivant la revendication 1 comportant un dispositif de réception de signaux numériques, qui comporte un circuit de régulation de cadence qui est formé par un discriminateur de phase (PD) et un générateur de cadence (TG) réglable par ce discriminateur, et dans lequel le discriminateur de phase est chargé par les échantillons de signaux numériques reçus et dérive, à partir des échantillons, des signaux de régulation qui sont envoyés au générateur de cadence à des intervalles de temps prédéterminés par l'intermédiaire d'un dispositif de filtre (SF), caractérisé par le fait
que le dispositif de filtre (SF) prépare des signaux de régulation sous la forme

Ta(i) = a1(Te(i)-a2 Te(i-1)) + Ta(i-1) avec i = 1,...,n

a1, a2 étant un ensemble prédéterminé de coefficients de filtre, Ta(i) et Ta(i-1) des signaux filtrés de régulation apparaissant aux instants i et (i-1), et Te(i) et Te(i-1) représentant des signaux de régulation préparés aux instants i et (i-1), à partir du discriminateur de phase (PD),
qu'au dispositif de filtre (SF) est raccordé un dispositif (SB) d'évaluation de signaux de régulation, qui est chargé par les signaux de régulation délivrés par le discriminateur de phase (PD) et, en fonction de l'écart instantané entre la valeur des signaux de régulation et une valeur de référence prédéterminée, prépare l'un d'au moins deux ensembles, qui diffèrent l'un de l'autre, de coefficients de filtre, pour le filtre en boucle, et
que les signaux filtrés de régulation sont envoyés au générateur de cadence (TG) par l'intermédiaire d'un quantificateur (Q).

5. Montage suivant la revendication 4, caractérisé par le fait
que le dispositif (SB) d'évaluation des signaux de régulation comporte un dispositif comparateur (SUB5, SW), qui indique au moyen d'un signal de commande délivré à sa sortie, si un signal de régulation précisément présent est supérieur ou inférieur à une valeur de seuil prédéterminée (REF)
qu'un dispositif de comptage progressif/régressif (Z) est chargé par une valeur minimale et une valeur maximale prédéterminées, avec des signaux de commande constituant des signaux de comptage, et
que le dispositif de comptage progressif/régressif envoie des signaux de sortie correspondant aux états de comptage, en tant que signaux d'adresses, à un dispositif (KS) de mémoire des coefficients de filtre, qui prépare des ensembles de coefficients de filtre pour le filtre en boucle (SF) en fonction de ces signaux d'adresses.

6. Montage suivant la revendication 4 ou 5, caractérisé par le fait
que le quantificateur (Q) comporte, côté entrée, un additionneur (ADD2) comportant 2 entrées, à l'une desquelles sont envoyés les signaux filtrés de régulation,

qu'un étage de quantification (QS), qui forme la sortie du quantificateur, est branché en aval de l'additionneur, et qu'à l'étage de quantification est raccordé un dispositif (SUB4, T2), qui envoie un signal d'erreur, qui correspond à une erreur de quantification apparaissant à l'instant (i-1), à l'entrée de l'additionneur (ADD2) à l'instant i.

7. Montage suivant l'une des revendications 4 à 6, caractérisé par le fait que dans le cas d'un dispositif de réception de signaux numériques comportant un dispositif de correction des distorsions (VEZ, NEZ) réglable par un coefficient principal de correction des distorsions et une multiplicité de coefficients de correction des distorsions précédant ou suivant ce coefficient principal, entre le filtre en boucle (SF) et le quantificateur (Q) est branché un additionneur (ADD3) comportant deux entrées, à l'une desquelles sont envoyés les signaux filtrés de régulation et à l'autre entrée desquelles est envoyé le coefficient de correction des distorsions éventuellement pondéré par un facteur fixe, qui précède ou suit directement le coefficient principal de correction des distorsions.

8. Montage suivant la revendication 7, caractérisé par le fait que le coefficient de correction des distorsions est envoyé à l'additionneur (ADD3) par l'intermédiaire d'un dispositif de commutation (S), lorsqu'est atteint un état prédéterminé de comptage du dispositif de comptage progressif/régressif (Z) associé au dispositif (SB) d'évaluation du signal de régulation.

9. Montage suivant l'une des revendications 5 à 8, caractérisé par le fait que le dispositif (SB) d'évaluation du signal de régulation prépare uniquement deux ensembles, qui diffèrent l'un de l'autre, de coefficients de filtre, qu'au filtre en boucle (SF) sont associées deux mémoires séparées (SP1, SP2) servant à mémoriser des signaux de régulation partielle (a1a2Te(i-2) + Ta(i-1), que dans le cas d'un état de comptage, supérieur à une valeur fixée, du dispositif de comptage progressif/régressif Z, une première mémoire (par exemple SP2) et un premier ensemble de coefficients de filtre, interviennent lors de la formation du signal filtré de régulation, tandis que dans le cas d'un état de comptage, inférieur à la valeur fixée, l'autre mémoire et l'autre ensemble de coefficients de filtre interviennent dans la formation d'un signal filtré de régulation, et que, lors d'un changement de la mémoire, le signal de régulation partiel contenu précisément dans la mémoire considérée reste mémorisé.

# FIG 1

# FIG 2

FIG 3

FIG 4

von KS

von Z